# EUROPEAN PATENT APPLICATION

(11) **EP 2 573 792 A1**
(43) Date of publication of application: **27.03.2013**
(21) Application number: 11783212.1
(22) Date of filing: 20.04.2011
(51) Int. Cl.: H01J 37/04, H01J 37/147

(54) **ELECTRON MICROSCOPE, AND METHOD FOR ADJUSTING OPTICAL AXIS OF ELECTRON MICROSCOPE**

(30) Priority: 20.05.2010 JP 2010115884
(71) Applicant: Hitachi High-Technologies Corporation, Tokyo 105-8717 (JP)
(72) Inventor: OYAGI, Toshiyuki, Hitachinaka-shi Ibaraki 312-8504 (JP); YOTSUJI, Takafumi, Hitachinaka-shi Ibaraki 312-8504 (JP); NODERA, Yasuyuki, Hitachinaka-shi Ibaraki 312-8504 (JP); NAGAOKI, Isao, Hitachinaka-shi Ibaraki 312-8504 (JP)
(74) Representative: Moore, Graeme Patrick
(86) International application number: PCT/JP2011/002302
(87) International publication number: WO 2011/145273

(57) **Abstract**

An electron microscope is provided that can automatically adjust the optical axis even in a state of deviation of the optical axis according to which the position of an electron beam on a fluorescent plate cannot be verified after replacement of an electron source. The microscope measures current of a fluorescent plate and determining whether the fluorescent plate is irradiated with an electron beam or not; without irradiation, controls a deflector to move the electron beam such that the fluorescent plate is irradiated with the electron beam; and, with irradiation, controls the deflector such that the current becomes a local maximum and a magnitude of luminance acquired from the image of the electron beam with which the fluorescent plate is irradiated becomes a local maximum.

## Description

### Technical Field

The present invention relates to an electron microscope and, more specifically, to a method for adjusting the optical axis of an electron beam which is performed after an operation of replacing an electron source.

### Background Art

Typically, electron sources of electron microscopes are tungsten filaments, lanthanum hexaboride filaments and the like. In an electron microscope, the electron source deteriorates and is broken. Accordingly, an operation of replacing the electron source is performed. The electron source is stored in a housing, which is referred to as an electron gun, and connected to a mirror body of a main body of the electron microscope. The operation of replacing the electron source in the electron gun is performed according to following procedures. In the procedures, an operator separates the electron gun from the mirror body and raises the gun, replaces the electron source, lowers the electron gun after the replacement, and connects the gun to the mirror body. Accordingly, it is difficult to avoid deviation between the central axis of the electron source and the central axis of the electron microscope. Thus, after replacement of the electron source, an operation of aligning the optical axes is always performed.

For instance, as to a transmission electron microscope, an operator visually inspects an image of an electron beam which has been emitted from the electron source and with which a fluorescent plate has been irradiated, and adjusts the optical axis by manually adjust a deflector which deflects an electron beam according to experience and instinct such that the optical axis of the electron beam coincides with the center of the fluorescent plate. In recent years, instead of direct visual inspection of a fluorescent plate, a method has been performed according to which a television camera for imaging the fluorescent plate has been provided in an electron microscope, or a television camera for taking an image having passed through a specimen immediately below the specimen has been provided, and an operator adjusts the optical axis while verifying the electron beam image taken by the television camera on a display (e.g., see Patent Literature 1).

The optical axis is adjusted by changing the intensity of a deflection coil provided in a mirror body of the electron microscope to move the optical axis of the electron beam and to thereby align the axis with a desired position, such as the center of a fluorescent plate. Thus, the operation of adjusting optical axis requires experience on how much the optical axis moves by application of voltage to the deflection coil. An automatic adjustment function independent from the experience of an operator is required for the electron microscope. As an attempt of automatization, a technique has been proposed which adjusts a horizontal component of an electron beam on the basis of an image taken by a television camera and adjusts an inclination component on the basis of an amount of beam current of the electron beam (e.g., see Patent Literature 2). However, a situation is not assumed where the fluorescent plate is not irradiated with an electron beam at all after replacement of the electron source. Accordingly, the adjustment requires a manual operation. Thus, an attempt which completely automatizes adjustment of the optical axis of an electron beam after replacement of an electron source has not been realized yet.

### Citation List

### Patent Literature

Patent Literature 1: JP Patent Publication (Kokai) No. 5-266840 A (1993)
Patent Literature 2: JP Patent Publication (Kokai) No. 2002-117794 A (2002)

### Summary of Invention

### Technical Problem

It is an object of the present invention to provide an electron microscope capable of automatically adjusting the optical axis even in a state of deviation of the optical axis according to which the position of an electron beam on a fluorescent plate cannot be verified after replacement of an electron source.

### Solution to Problem

In order to solve the problem, an aspect of the present invention measures current of a fluorescent plate and determines whether the fluorescent plate is irradiated with an electron beam or not; if the fluorescent plate is not irradiated, controls a deflector to move the electron beam such that the fluorescent plate is irradiated with the electron beam; and, if the fluorescent plate is irradiated, controls the deflector such that the current becomes a local maximum and a magnitude of luminance acquired from the electron beam with which the fluorescent plate is irradiated becomes a local maximum.

### Advantageous Effects of Invention

According to the above configuration, the present invention can provide an electron microscope capable of automatically adjusting the optical axis even in a state of deviation of the optical axis according to which the position of an electron beam on a fluorescent plate cannot be verified after replacement of an electron source.

### Brief Description of Drawings

[Figure 1] Figure 1 is a configurational diagram showing a main configuration of a transmission electron microscope.
[Figure 2] Figure 2 is a configurational diagram showing the main configuration of the transmission electron microscope.
[Figure 3] Figure 3 is a screen diagram showing an example of a screen displayed on a display.
[Figure 4] Figure 4 is a screen diagram showing an example of a screen displayed on the display.
[Figure 5] Figure 5 is a screen diagram showing an example of a screen displayed on the display.
[Figure 6] Figure 6 is a flowchart showing procedures of adjusting the optical axis.
[Figure 7] Figure 7 is a screen diagram showing an image of a fluorescent plate displayed on the display.
[Figure 8] Figure 8 is a screen diagram showing an image of a fluorescent plate displayed on the display.
[Figure 9] Figure 9 is a flowchart showing a process of roughly adjusting a deflection coil in step 606 in Figure 6 in detail.
[Figure 10] Figure 10 is a conceptual diagram showing movement of the optical axis of an electron beam 4 in an x-axis and a y-axis of an inclination deflection coil.
[Figure 11] Figure 11 is a conceptual diagram showing movement of the optical axis of the electron beam 4 in an x-axis and a y-axis of a positional deflection coil.
[Figure 12] Figure 12 is a flowchart showing a process of finely adjusting the deflection coil in step 607 in Figure 6 in detail.
[Figure 13] Figure 13 is a flowchart showing a process of setting inclination deflection local maximum current in step 1202 in Figure 12 in detail.
[Figure 14] Figure 14 is a correlation diagram showing relationship between a current value Ix acquired from the fluorescent plate and an amount of deflection GT-x due to the inclination deflection coil.
[Figure 15] Figure 15 is a flowchart showing a process of setting inclination deflection local maximum luminance in step 611 in Figure 6 in detail.

### Description of Embodiments

An embodiment of the present invention will hereinafter be described with reference to drawings.

### Embodiment

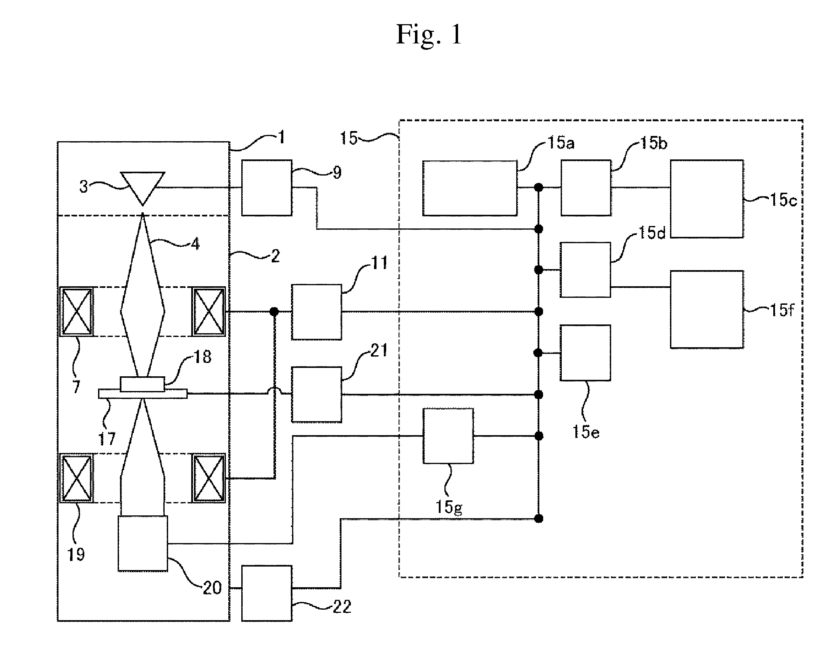

Figure 1 is a configurational diagram showing a main configuration of a transmission electron microscope. An electron beam 4 which has been emitted from an electron source 3 and with which a specimen 18 has been irradiated passes through the specimen 18. The beam is imaged by an imaging device, such as a television camera 20, transmitted to a control device 15, and displayed on a display or the like. The electron source 3 is arranged in a housing, which is referred to as an electron gun 1. The electron gun 1 and a mirror body 2 of a main body of the electron microscope are connected to each other. Subsequently, the interior is maintained to vacuum. The electron source 3 may be any of various types, such as a tungsten filament, a lanthanum hexaboride filament, a thermionic gun, a field emission electron gun, a Schottky electron source. The present invention is applicable to any of these electron sources.

The mirror body 2 internally includes an electromagnetic lens 7 which converges the electron beam 4 on the specimen 18, an image-forming lens 19 which converges the beam on a television camera 20, and a specimen stage 17 which fixes the specimen 18. An acceleration voltage, a filament voltage and a bias voltage are applied to the electron source 3 by an electron source controller 9, and an electron beam 4 is generated. The inside of the mirror body 2 is maintained vacuum by a vacuum exhausting device 22. The electromagnetic lens 7 and the image-forming lens 19 supplied with current by the electromagnetic lens controller 11, and the lens intensities are changed. The specimen stage 17 is driven by a specimen controller 21, and the position in three-dimensional directions is changed.

A control device 15 provided outside of the mirror body 2 causes a processor 15a to execute a program stored in a memory 15e to thereby issue, to an electron source controller 9, an instruction of supplying an electron source 3 with an acceleration voltage, issue, to an electron beam controller 10, an instruction of supplying a positional deflection coil 5 and an inclination deflection coil 6 with current, and issue, to the electromagnetic lens controller 11, an instruction of supplying the electromagnetic lens 7 and the image-forming lens 19 with current. An image signal acquired by imaging by the television camera 20 is transmitted to an image processor 15g, and stored in a memory 15d which temporarily stores an image and an image storing memory 15f which can store a large amount of images. The image signal is temporarily stored in a memory 15b, displayed on a display externally connected via the input output interface 15c, and stored in a mass storage device.

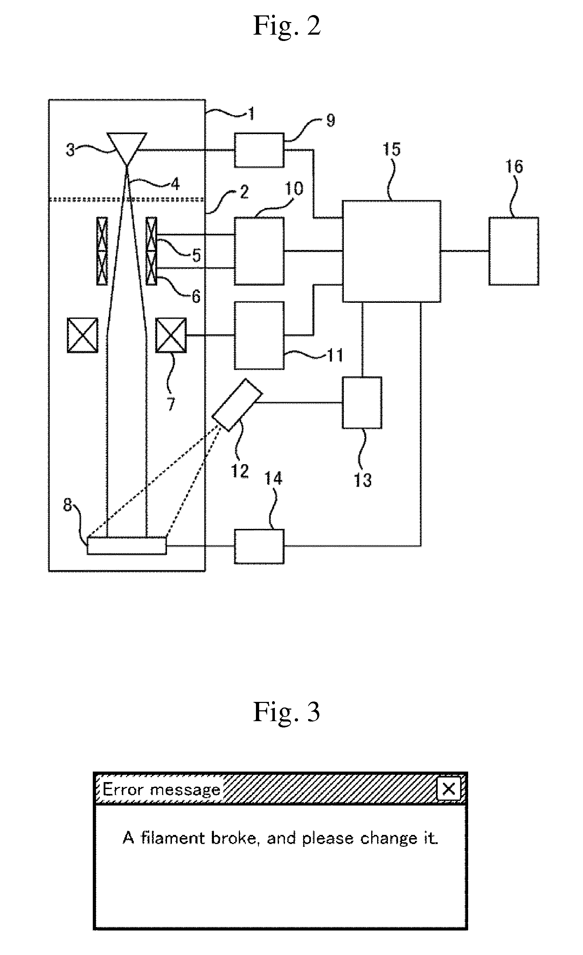

Figure 2 is a configurational diagram showing the main configuration of the transmission electron microscope. As to the transmission electron microscope, an operator visually inspects an electron beam image of a fluorescent plate 8 to thereby adjust the optical axis. In this embodiment, an electron beam image of the fluorescent plate 8 is imaged by a television camera 12 and transmitted to the control device 15 via an image processor 13, and the luminance of the electron beam image is acquired and displayed on a display 16. The fluorescent plate 8 is connected with a current measuring device 14. The current value varying by irradiation on the fluorescent plate 8 with the electron beam 4 is measured. The current value is transmitted to the control device 15.

For the sake of adjusting the optical axis of the electron beam 4, the mirror body 2 internally includes the positional deflection coil 5 and the inclination deflection coil 6. The positional deflection coil 5 controls the horizontal position and the vertical position of the electron beam 4. The inclination deflection coil 6 controls the inclination angle. According to an instruction from the control device 15, the electron beam controller 10 adjusts the intensities of the positional deflection coil 5 and the inclination deflection coil 6. According to an instruction from the control device 15, the electromagnetic lens controller 11 adjusts the intensity of the electromagnetic lens 7.

The electron gun 1 provided with the electron source 3 is connected to the mirror body 2, which is the main body of the electron microscope. However, in an operation of replacing the electron source 3 in the electron gun 1, the electron gun 1 and the mirror body 2 are separated from each other. In the operation of replacing the electron source 3, which is attached into the electron gun 1, the electron gun 1 should be raised and separated from the mirror body 2. After replacement of the electron source 3, the electron gun 1 is lowered and integrated with the mirror body 2. Slight errors of the attachment position of the electron source 3 and the setting position due to raising and lowering of the electron gun 1 cause a deviation between the electron beam optical axes of the electron gun 1 and the mirror body 2. The deviation brings a state where the electron beam 4 is not displayed on the fluorescent plate 8, or adjustment is required even if the electron beam 4 is displayed.

If the optical axis of the electron beam 4 coincides with the center of the fluorescent plate 8, the current value of the fluorescent plate 8 becomes a local maximum value, and the luminance acquired from an image of the electron beam on the fluorescent plate 8 also becomes a local maximum value. Accordingly, the control device 15 calculates the current value of the fluorescent plate 8 and the luminance value of the of the electron beam image, calculates control data to be transmitted to each controller such that each value becomes a local maximum value, and transmits the data. On the basis of the control data, the positional deflection coil 5 and the inclination deflection coil 6 adjusts the optical axis of the electron beam 4.

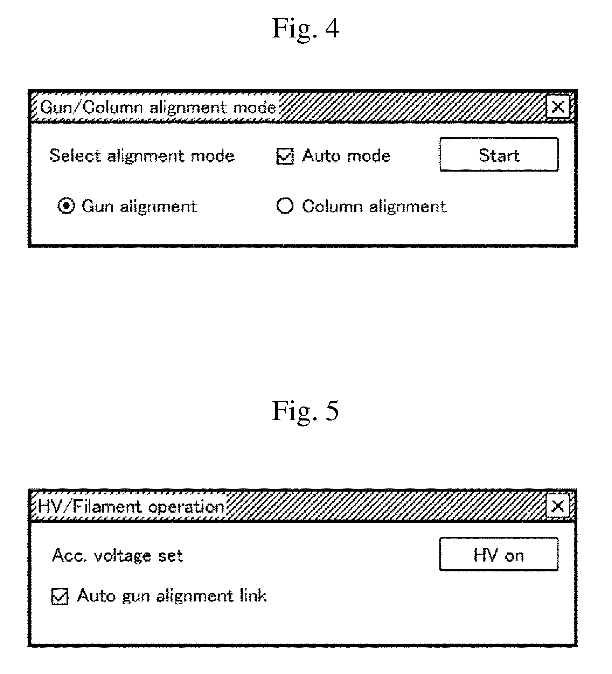

Figures 3, 4 and 5 are screen diagrams showing example of screens displayed on the display 16. Figure 3 shows the example of the screen for displaying a message warning an operator of the electron microscope when breakage of the electron source 3 is detected. When the screen is displayed, the operator stops the electron microscope, and replaces the electron source 3. Figure 4 shows the example of the screen for selecting whether adjustment of the optical axis of the electron source 3 or adjustment of the optical axis of the mirror body 2 is performed and for automatically performing the optical axis adjustment. This screen is displayed after the replacement of the electron source 3. On automatic adjustment of the optical axis, the operator does not immediately know the optimal values of the acceleration voltage and the emission current of the electron source 3. Accordingly, it is complicated to manually input these values. To address therewith, subsequent to the screen of Figure 4, the screen of Figure 5 is displayed, and the operator designates a button for designating application of an acceleration voltage. Accordingly, the control device 15 shown in Figure 2 executes a program for automatically setting preset acceleration voltage and emission current and subsequently executes a program for adjusting the optical axis together therewith to automatically adjust the optical axis.

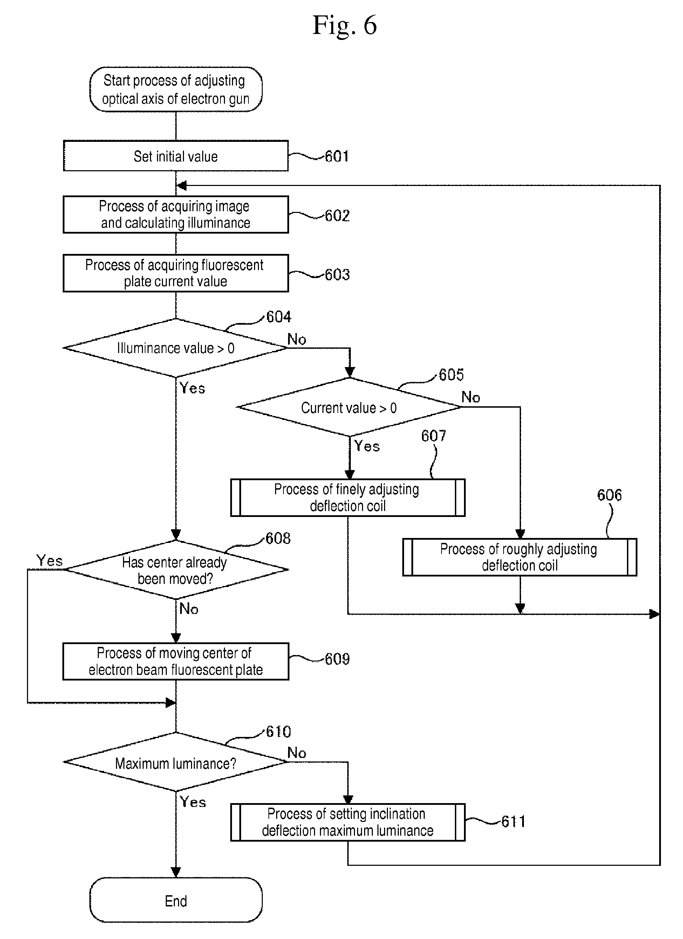

Figure 6 is a flowchart showing procedures of an optical axis adjusting process. The control device 15 shown in Figure 2 outputs the control data acquired by executing the procedure shown in Figure 6, and controls the positional deflection coil 5 and the inclination deflection coil 6, thereby automatically performing optical axis adjustment. The procedures shown in Figure 6 represent the main part of the present invention. Detailed procedures omitted will be described with reference to other drawings.

In Figure 6, first, initial values of the positional deflection coil 5 and the inclination deflection coil 6 are set (step 601). Here, as the initial values, an origin point is set in the positional deflection coil 5, and a value where the inclination is 0° is set in the inclination deflection coil 6. Owing to a manufacturing process of the electron microscope and an individual difference due to other factors, the origin point of the coil does not necessarily coincide with the optical axis. In this case, a value corrected such that the mirror body 2 is adjusted to a reference optical axis is adopted as the initial value. This allows deviation due to the individual difference of the electron microscope to be eliminated. Accordingly, it is only required to adjust the error of the optical axis with respect to the attachment position of the electron source 3.

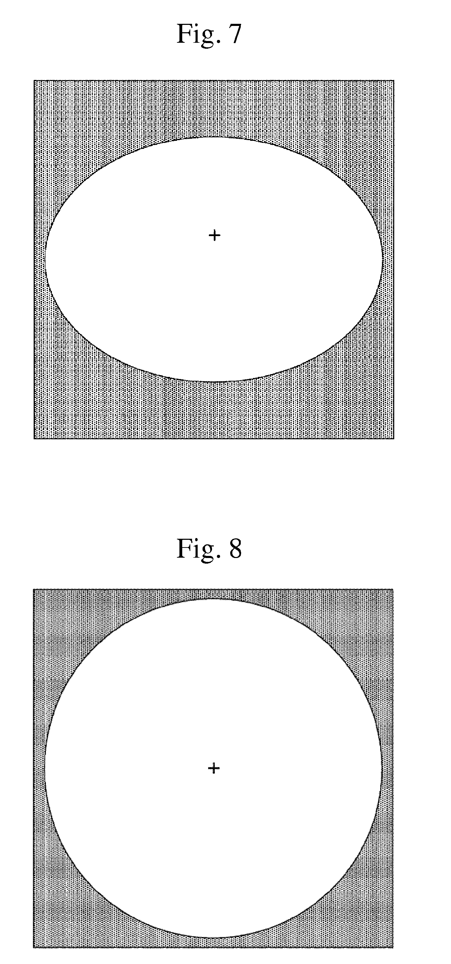

Figures 7 and 8 are screen diagrams showing images of the fluorescent plate displayed on the display 16. The control device 15 acquires a luminance value from an image taken by the television camera 12 imaging the fluorescent plate 8 shown in Figure 2 (step 602). As shown in Figure 2, the image of the fluorescent plate 8 is taken in an oblique direction. Accordingly, for instance, in the case where an image of a circle is taken, if the image is displayed on the display as it is, the image is displayed as an elliptically deformed shape as shown in Figure 7. The control device 15 performs an image converting process which corrects the elliptic image to a circle. The electron beam image is displayed as the image of the circle on the display 16 as shown in Figure 8. After the image converting process, the control device 15 acquires the luminance value from the gradation values of the image. For instance, the total sum of luminance values of pixels in the image is acquired, and divided by the number of pixels. This average value is adopted as the luminance value. In the case where the fluorescent plate 8 is not irradiated with the electron beam 4, the luminance value is approximately zero.

Next, the current value of the fluorescent plate 8 is measured by the current measuring device 14, and transmitted to the control device 15 (step 603). If the illuminance value cannot be acquired when the initial value is set in the deflection coil, it is determined that the fluorescent plate 8 is not irradiated with the electron beam which can be imaged. However, there is a possibility that the fluorescent plate 8 is irradiated with a minute electron beam. Accordingly, even if the luminance value cannot be acquired, the control device 15 can adjust the optical axis on the basis of the current value.

It is determined whether the luminance value has been acquired in the calculation process in step 602 or not (step 604). If the luminance value has not been acquired, it is determined whether the current value has been acquired or not (step 605). If the current value has not been acquired, the values of the positional deflection coil 5 and the inclination deflection coil 6 are changed, and the electron beam 4 is moved, thus performing rough adjustment (step 606), and the luminance value is calculated again in step 602 and the current value is calculated again in step 603. The details of roughly adjusting process in step 606 will be described later.

If the current value has been acquired in step 605, it is represented that the fluorescent plate 8 is irradiated with the electron beam 4. Accordingly, the values of the positional deflection coil 5 and the inclination deflection coil 6 are changed, and the electron beam 4 is moved, thus performing fine adjustment (step 607), and the illuminance value is calculated again in step 602, and the current value is calculated again in step 603. The details of the fine adjustment process in step 607 will be described later. Repetition of the above processes allows the fluorescent plate 8 to be irradiated with the electron beam 4, which allows the luminance value to be acquired.

If the luminance value has been acquired in step 604, a process of causing the positional deflection coil 5 to move the electron beam 4 to the coordinates of the center of the fluorescent plate 8 is performed (step 609). Since this process is required to be performed only one time, it is determined whether or not this process has been performed therebefore (step 608). The control device 15 acquires the difference between the current positional coordinates of the electron beam 4 acquired by the process of finely adjusting the deflection coil in step 607 and the coordinates of the center of the fluorescent plate 8, adopts the difference as the amount of movement, and transmits an instruction of deflecting the electron beam 4 to the positional deflection coil 5. If the illuminance value has been acquired in step 604, the current positional coordinates of the electron beam 4 cannot be detected. Accordingly, the control device 15 uses a preset amount of movement, and transmits the instruction of deflecting the electron beam 4 to the positional deflection coil 5.

Subsequently, it is determined whether the luminance acquired from the fluorescent plate 8 is a local maximum value or not (step 610). The control device 15 acquires the image of the fluorescent plate 8, and calculates the luminance value. The correct position of the optical axis cannot be acquired from the luminance distribution on the fluorescent plate 8. However, for instance, it can be estimated that the position of the optical axis when the total amount and the average value of luminance values acquired from the fluorescent plate 8 are local maximums is the position coinciding with the center of the fluorescent plate 8. Accordingly, the number of luminance values is one at the first time. However, after the third time, it can be determined whether the value is a local maximum value or not. Repetition thereof allows acquiring the position of the optical axis when the total amount or the average value of luminance values is a local maximum.

If the luminance value is not a local maximum value in step 610, an after-mentioned process of setting inclination deflection local maximum luminance is performed (step 611), processes in and after step 602 are subsequently performed again, and processing is continued until the local maximum value is reached in the luminance value determination in step 610.

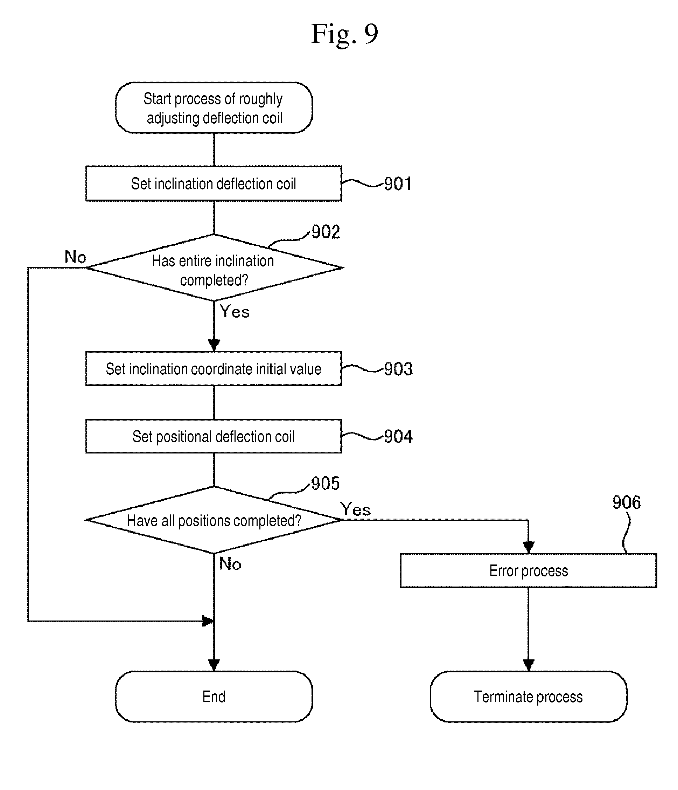

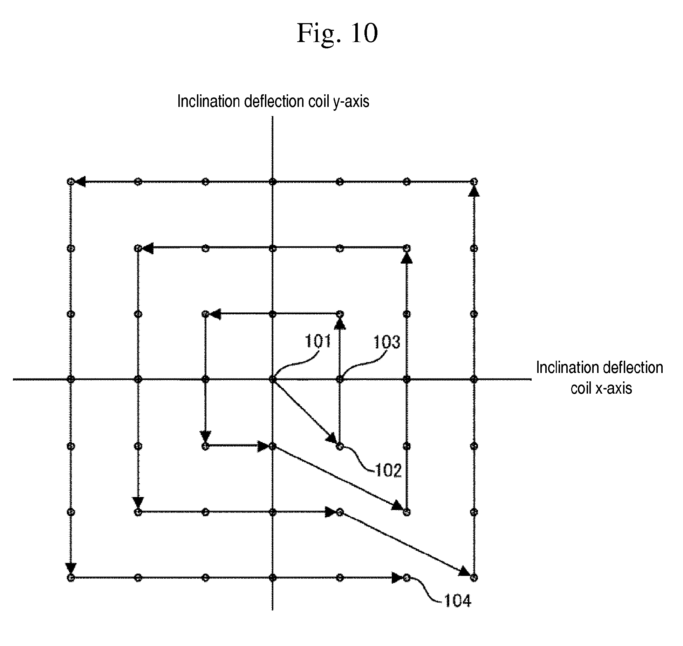

Figure 9 is a flowchart showing the details of the process of roughly adjusting the deflection coil in step 606 in Figure 6. Figure 10 is a conceptual diagram showing movement of the optical axis of the electron beam 4 in the x-axis and the y-axis of the inclination deflection coil. The electron beam 4 is deflected sequentially from a point 101 to a point 104. The range represented by the last point 104 is set so as to cover the entire region of the fluorescent plate 8. The process of roughly adjusting the deflection coil is a process of acquiring the current value in a state where the luminance value and the current value are not acquired and the fluorescent plate 8 is not irradiated with the electron beam 4. The control device 15 calculates the inclination coordinates, and sets coordinate data in the inclination deflection coil 6, thereby inclining the electron beam 4 (step 901). In Figure 10, the initial state is the point 101. When the electron beam 4 is inclined by a certain value, the point 102 is reached. Then, the electron beam 4 is deflected by a position corresponding to the point 102. Many inclination coordinates exist reaching to the point 104 as shown in Figure 10. In the state of the point 102, processing has not been completed yet on the entire inclination (step 902), the following steps are not performed but the processing returns to step 602 in Figure 6. The illuminance calculation in step 602 to the current measurement in step 603 are performed, and the determination of steps 604 and 605 are performed. As a result of the determination, if another roughly adjusting process is required, the procedures shown in Figure 9 are performed again. The starting point at this time is the point 102 in Figure 10. The electron beam 4 is inclined from the point 102 to the point 103 in Figure 10 (step 901). Since the entire inclination has not been completed according to the determination in step 902, the processing returns to step 602 in Figure 6 again and this processing is repeated. At the last point 104 in Figure 10, it is determined that the entire inclination has not been completed yet in step 902 in Figure 9 and the processing returns to step 602 in Figure 6. If the luminance value has not been acquired in step 604 in Figure 6 and the current value has not been acquired in step 605, the process of roughly processing the deflection coil shown in 606 whose details are shown in Figure 9 is performed again, change of the inclination deflection coil 6 in step 901 in Figure 9 is not performed because there is no point after the last point 104 in Figure 10. In step 902, the control device 15 determines that the processing has been completed on the entire inclination, returns the value of the inclination deflection coil 6 to the initial value (step 903), deflects the electron beam 4 using only the positional deflection coil 5, and changes the position of the optical axis (step 904).

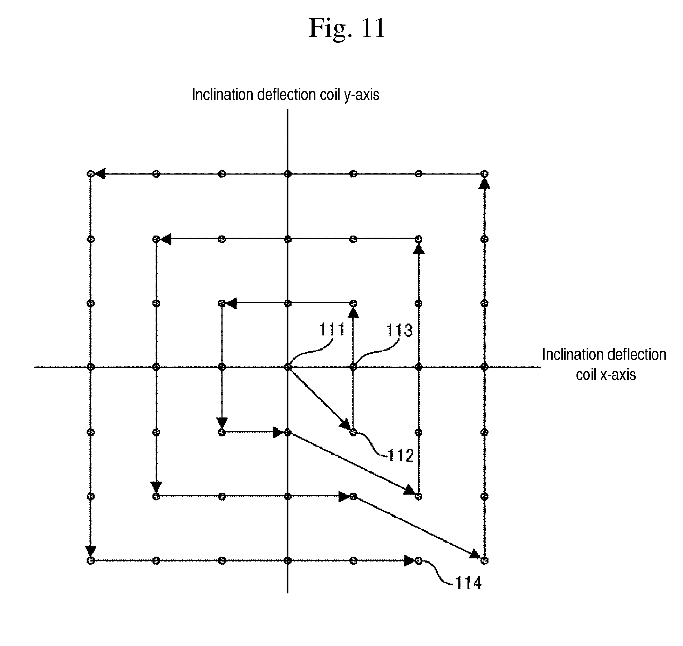

Figure 11 is a conceptual diagram showing movement of the optical axis of the electron beam 4 in the x-axis and the y-axis of the positional deflection coil. The range represented by the last point 114 is set so as to cover the entire region of the fluorescent plate 8. The control device 15 shown in Figure 2 sets the positional coordinates to the initial value represented by the point 111 in Figure 11, and determines whether setting of all the positions have been completed or not (step 905), the procedures shown in Figure 9 are finished because the point is the point 111 as the initial value at this time, executes steps 602 and 603 shown in Figure 6, and determines whether to have acquired the luminance value and the current value. If both the values have not been acquired, the processing returns to the procedure in step 606 in Figure 9, and the procedures in and after step 901 are repeated until the luminance value or the current value is acquired. In step 904 shown in Figure 9, the points 111, 112 and 113 to the last point 114 shown in Figure 11 are setting positions of the positional deflection coil 5.

If neither the luminance value nor current value is acquired in step 905 in Figure 9 even at the last point 114 shown in Figure 11, problems are considered in that irradiation with the electron beam 4 is not performed, and irradiation in a misdirected direction is performed; these problems should be considered before adjustment of the optical axis. Accordingly, in this case, an error message is displayed on the display or the like, and the optical axis adjusting process is finished (step 906). For instance, in the case where a failed electron source is attached by mistake when the electron source is replaced, the electron beam is not emitted. In the case where attachment of the electron source is insufficient and the electron source is not attached at the regular position or falls out, the electron beam is not emitted.

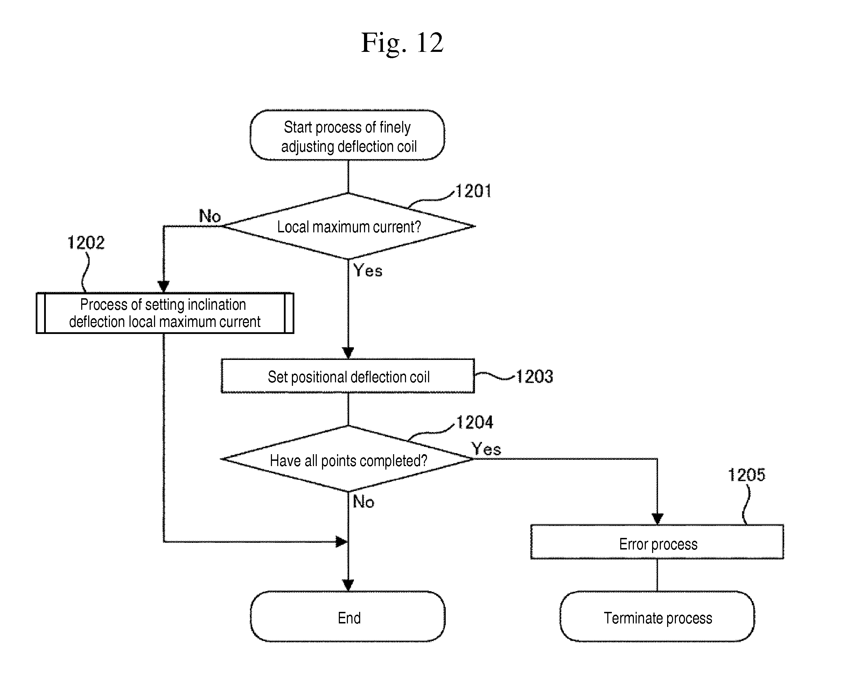

Figure 12 is a flowchart showing the details of the process of finely adjusting the deflection coil in step 607 in Figure 6. The process of finely adjusting the deflection coil causes the inclination deflection coil 6 and the positional deflection coil 5 to deflect the electron beam 4 in a direction of increasing the current value acquired from the fluorescent plate 8, and acquires the luminance value from the image of the fluorescent plate 8.

The setting value in the inclination deflection coil 6 and the setting value in the positional deflection coil 5 acquired by the process of roughly processing the deflection coil in step 606 in Figure 6 are used as the initial values. First, it is determined whether the current value of the fluorescent plate 8 measured in step 603 in Figure 6 is a local maximum value or not (step 1201). That is, if the value at the last time is larger than the value at this time and the value one time before the last value is smaller than the last value, it can be determined that the value at the last time is the local maximum. Since the number of values are one at first and it cannot be determined whether the value is the local maximum or not, a process is performed which changes the setting value in the inclination deflection coil 6 such that the current value becomes the local maximum (step 1202). The details of the process will be described later.

If the current value of the fluorescent plate 8 is the local maximum in step 1201, the point 111 shown in Figure 11 is adopted as the initial value and the setting value in the positional deflection coil 5 is changed to deflect the electron beam 4, thereby changing the position of the optical axis (step 1203). Here, the optical axis of the electron beam 4 of the positional deflection coil shown in Figure 11 on the x-axis and the y-axis is moved. The range represented by the last point 114 is set so as to cover the entire region of the fluorescent plate 8. The control device 15 sets the positional coordinates to the initial value indicated by the point 111 in Figure 11, determines whether the processes on all the points have been finished or not (step 1204), finishes the procedures shown in Figure 12 because the point is the point 111 as the initial value at the first time, exits from step 607 shown in Figure 6, performs steps 602 and 603, and determines whether the luminance value and the current value have been acquired or not. If the luminance value has not been acquired but the current value has been acquired, the process shown in step 607 in Figure 12 is performed again.

If all the positions are completed without acquiring the luminance value in step 1204, it is detected that the optical axis of the electron beam 4 has not been found at all even though the point 114 in Figure 11 is reached. Accordingly, there are problems that should be considered before adjustment of the optical axis. Thus, in this case, the error message is displayed on the display 16 or the like, and the optical axis adjusting process is finished (step 1205). As to errors, for instance, in the case where a failed electron source is attached by mistake when the electron source is replaced, the electron beam is not emitted. In the case where attachment is insufficient and the electron source is not attached to the regular position or falls out, the electron beam is not emitted. Accordingly, the control device 15 causes the display 16 to display a message corresponding thereto.

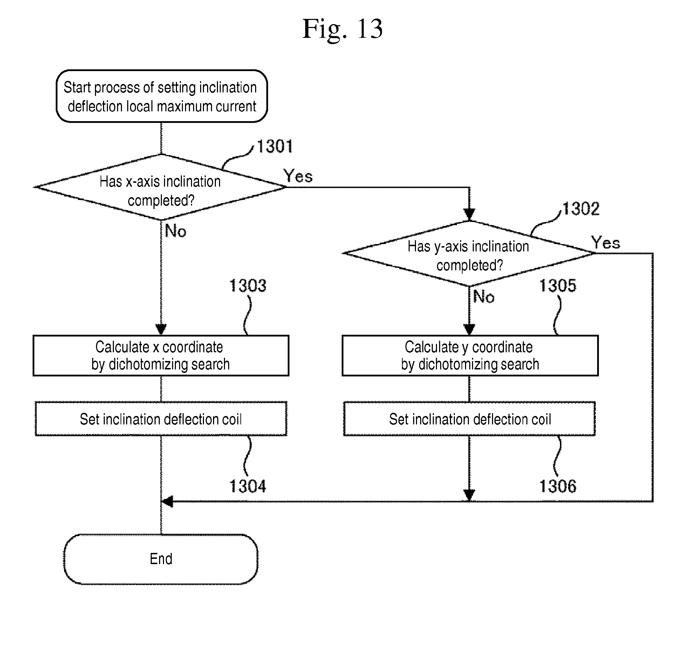

Figure 13 is a flowchart showing the details of the process of setting inclination deflection local maximum current in step 1202 in Figure 12. The deflection of the electron beam in the x direction due to the inclination deflection coil 6 is defined as GT-x. The deflection in the y direction is defined as GT-y. First, it is determined whether the inclination of the x-axis due to the inclination deflection coil 6 has been completed or not (step 1301). If the inclination has been completed, it is determined whether the inclination in the y-axis has been completed or not (step 1302).

If the inclination in the x-axis has not completed yet in step 1301, dichotomizing search is used on the x-axis to acquire a deflection value GT-xmax in the x direction where the current value of the fluorescent plate 8 is a local maximum (step 1303). The value is adopted as the setting value in the inclination deflection coil 6 (step 1304), the process of setting inclination deflection local maximum current shown in Figure 13 has been finished, step 1202 shown in Figure 12 is finished, and the process of finely adjusting the deflection coil is finished, thereby finishing step 607 shown in Figure 6.

If it is determined that the inclination of the y-axis has not been completed in step 1302, dichotomizing search is used on y-axis to acquire a deflection value GT-ymax in the y direction where the current value of the fluorescent plate 8 is a local maximum (step 1305). The value is adopted as the setting value of the inclination deflection coil 6 (step 1306), the process of setting inclination deflection local maximum current shown in Figure 13 is finished, step 1202 shown in Figure 12 is finished, and the process of finely adjusting the deflection coil is finished, thereby finishing step 607 show in Figure 6.

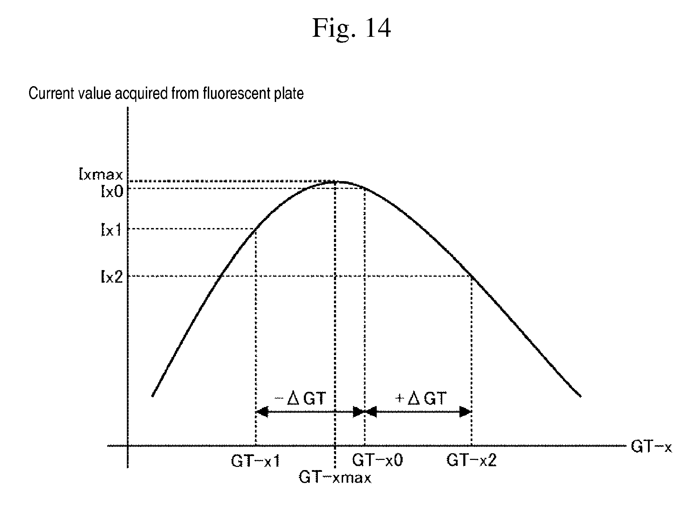

Figure 14 is a correlation diagram showing relationship between a current value Ix acquired from the fluorescent plate 8 and the amount of deflection GT-x due to an inclination deflection coil 6. Referring to Figure 14, a method of acquiring a direction of increasing the current value in the x-axis direction according to dichotomizing search and setting coordinates at this time will be described. The deflection in the x direction of the electron beam due to the inclination deflection coil 6 is GT-x. The initial value is GT-x0. The current value acquired from the fluorescent plate 8 when the initial value GT-x0 is set in the inclination deflection coil 6 is denoted by Ix0. Next, the amount of deflection when the initial value GT-x0 of the amount of deflection is decreased by ΔGT is denoted by GT-x1. The current value acquired from the fluorescent plate at this time is measured, and the current value is denoted by Ix1. Next, the amount of deflection increased from the initial value GT-x0 by ΔGT is denoted by GT-x2. The current value acquired from the fluorescent plate at this time is measured, and the current value is denoted as Ix2. Use of dichotomizing search can acquire the local maximum value Ixmax of the current value Ix, and the amount of deflection GT-xmax at this time. Also on the y-axis direction, dichotomizing search identical to that on the x-axis direction sets the amount of deflection GT-ymax corresponding to the local maximum value Iymax of the current value. For instance, when the current value Ix2 is larger than the current value Ix0 in Figure 14, the current value Ix2 is the local maximum value Ixmax, and the amount of deflection GT-x2 corresponding to the current value Ix2 is set.

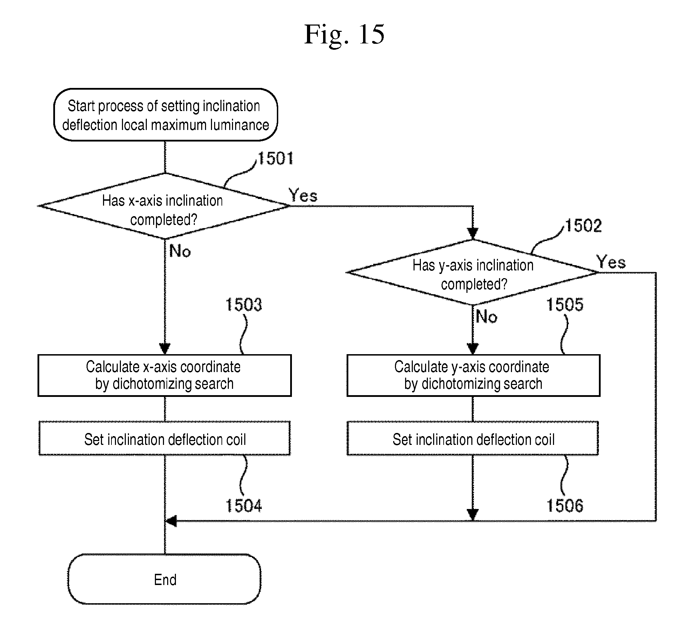

Figure 15 is a flowchart showing the details of the process of setting inclination deflection local maximum luminance in step 611 in Figure 6. In comparison with the process of acquiring the local maximum current value shown in Figure 13, this process is a process the current value is replaced with the luminance value. The concept of the process is the same. It is defined that the deflection of the electron beam in the x direction due to the inclination deflection coil 6 is defined as GT-x, and the deflection in the y direction is defined as GT-y. First, the inclination of the x-axis due to the inclination deflection coil 6 has been completed or not (step 1501). If the inclination has been completed, it is determined whether the inclination of the y-axis has been completed or not (step 1502).

It is determined that the inclination of the x-axis has not been completed in step 1501, dichotomizing search is used on the x-axis to acquire the deflection value GT-xmax in the x direction where the luminance value of the fluorescent plate 8 is a local maximum (step 1503). The value is adopted as the setting value in the inclination deflection coil 6 (step 1504), and the process of setting inclination deflection local maximum luminance shown in Figure 15 is finished, and step 611 shown in Figure 6 is finished.

If it is determined that the inclination of the y-axis has not been completed in step 1502, dichotomizing search is used on the y-axis, the deflection value GT-ymax in the y direction where the luminance value of the fluorescent plate 8 is a local maximum is acquired (step 1505). The value is adopted as the setting value in the inclination deflection coil 6 (step 1506), the process of setting inclination deflection local maximum luminance shown in Figure 15 is finished, and the process in step 611 shown in Figure 6 is finished.

The embodiment of the present invention uses both the minute current value acquired from the fluorescent plate and the luminance value of the electron beam with which the fluorescent plate is irradiated, the electron beam is deflected while both the values are verified, thereby allowing adjustment of the optical axis of the electron beam to be automatized. Accordingly, anyone can easily and correctly adjust the optical axis of the electron beam after replacement of the electron source without depending on experience and instinct. Furthermore, after replacement of the electron source, adjustment of the optical axis of the electron beam is automatically performed together with the operation of applying the acceleration voltage, thereby allowing the operator of the electron microscope to handle the electron microscope without concerning adjustment of the optical axis.

### Reference Signs List

- 1: electron gun
- 2: mirror body
- 3: electron source
- 4: electron beam
- 5: positional deflection coil
- 6: inclination deflection coil
- 7: electromagnetic lens
- 8: fluorescent plate
- 9: electron source controller
- 10: electron beam controller
- 11: electromagnetic lens controller
- 12, 20: television camera
- 13: image processor
- 14: current measuring device
- 15: control device
- 16: display
- 17: specimen stage
- 18: specimen
- 19: image-forming lens
- 21: specimen controller
- 22: vacuum exhausting device

## Claims

1. An electron microscope, comprising:
an imaging device which takes an image of an electron beam with which a fluorescent plate is irradiated;
a current measuring device which measures current of the fluorescent plate; and
a control device which acquires a luminance from the image of the electron beam transmitted from the imaging device, and outputs an instruction to a deflection coil which deflects an optical axis of the electron beam on the basis of a value of the luminance or a value of the current.

2. The electron microscope according to claim 1,
wherein, if the value of the luminance or the value of the current cannot be acquired, the control device outputs the instruction to the deflection coil for moving the optical axis of the electron beam, determines again whether the value of the luminance or the value of the current is acquired or not, and repeats outputting the instruction to the deflection coil for moving the optical axis of the electron beam and determining whether the value of the luminance or the value of the current is acquired or not until the value of the luminance or the value of the current is acquired.

3. The electron microscope according to claim 1,
wherein, if the value of the luminance is not acquired, the control device verifies the value of the current.

4. The electron microscope according to claim 3,
wherein, if the value of the current is not acquired, the control device outputs the instruction to the deflection coil for moving the optical axis of the electron beam.

5. The electron microscope according to claim 3,
wherein, if the value of the current is acquired, the control device determines whether the value of the current is a local maximum or not, and, if the value is not the local maximum, the control device outputs the instruction to the deflection coil for inclining the optical axis of the electron beam.

6. The electron microscope according to claim 5,
wherein the control device moves the optical axis of the electron beam to a plurality of coordinate points provided on the fluorescent plate, and outputs an error message if the value of the current is not the local maximum even in a case of moving the optical axis of the electron beam to all of the plurality of coordinate points.

7. The electron microscope according to claim 3,
wherein, if the value of the current is acquired, the control device determines whether the value of the current is a local maximum or not, and, if the value is the local maximum, outputs the instruction to the deflection coil for horizontally moving the optical axis of the electron beam.

8. The electron microscope according to claim 1,
wherein, if the value of luminance is acquired, the control device outputs the instruction to the deflection coil for deflecting the optical axis of the electron beam.

9. The electron microscope according to claim 8,
wherein the control device determines whether the value of the luminance is a local maximum or not, and, if the value is not the local maximum, outputs the instruction to the deflection coil for inclining the optical axis of the electron beam.

10. A method for adjusting an optical axis of an electron microscope, the method comprising: measuring current of a fluorescent plate and determining whether the fluorescent plate is irradiated with an electron beam or not; if the fluorescent plate is not irradiated, controlling a deflector to move the electron beam such that the fluorescent plate is irradiated with the electron beam; and, if the fluorescent plate is irradiated, controlling the deflector such that the current becomes a local maximum and a magnitude of luminance acquired from the image of the electron beam with which the fluorescent plate is irradiated becomes a local maximum.

11. A method for adjusting an optical axis of the electron microscope, the method comprising:
acquiring a luminance from an image of an electron beam with which a fluorescent plate is irradiated;
measuring current of the fluorescent plate; and
deflecting the optical axis of the electron beam on the basis of the value of the luminance or the value of the current.

12. The method for adjusting the optical axis of the electron microscope according to claim 11, further comprising:
if the value of the luminance or the value of the current is not acquired, moving the optical axis of the electron beam; determining again whether the value of the luminance or the value of the current is acquired or not; and repeating moving the optical axis of the electron beam and determining whether the value of the luminance or the value of the current is acquired or not until the value of the luminance or the value of the current is acquired.

13. The method for adjusting the optical axis of the electron microscope according to claim 11, further comprising:
if the value of the luminance is not acquired, verifying the value of the current.

14. The method for adjusting the optical axis of the electron microscope according to claim 13, further comprising:
if the value of the current is not acquired, moving the optical axis of the electron beam.

15. The method for adjusting the optical axis of the electron microscope according to claim 13, further comprising:
if the value of the current is acquired, determining whether the value of the current is a local maximum or not; and, if the value is not the local maximum, inclining the optical axis of the electron beam.

16. The method for adjusting the optical axis of the electron microscope according to claim 15, further comprising:
moving the optical axis of the electron beam to a plurality of coordinate points provided on the fluorescent plate, and, if the value of the current is not the local maximum even in a case of moving the optical axis of the electron beam with respect to all of the plurality of coordinate points, outputting an error message.

17. The method for adjusting the optical axis of the electron microscope according to claim 13, further comprising:
if the value of the current is acquired, determining whether the value of the current is a local maximum or not, and, if the value is the local maximum, horizontally moving the optical axis of the electron beam.

18. The method for adjusting the optical axis of the electron microscope according to claim 11, further comprising:
if the value of the luminance is acquired, deflecting the optical axis of the electron beam.

19. The method for adjusting the optical axis of the electron microscope according to claim 18, further comprising:
determining whether the value of the luminance is a local maximum or not, and, if the value is not the local maximum, inclining the optical axis of the electron beam.

20. The method for adjusting the optical axis of the electron microscope according to claim 18, further comprising:
determining whether the value of the luminance is a local maximum or not, if it is determined that the value is the local maximum, finishing the process of adjusting the optical axis of the electron beam.
